(19) Europäisches Patentamt
European Patent Office
Office européen des brevets

(11) Veröffentlichungsnummer: **0 279 895 B1**

## (12) EUROPÄISCHE PATENTSCHRIFT

(45) Veröffentlichungstag der Patentschrift: **05.05.93**

(51) Int. Cl.5: **H01J 37/32**, C23C 16/50, H05H 1/46

(21) Anmeldenummer: **87111855.0**

(22) Anmeldetag: **17.08.87**

---

(54) **Enrichtung zum Herstellen eines Plasmas und zur Behandlung von Substraten darin.**

---

(30) Priorität: **21.02.87 DE 3705666**

(43) Veröffentlichungstag der Anmeldung:
**31.08.88 Patentblatt 88/35**

(45) Bekanntmachung des Hinweises auf die Patenterteilung:
**05.05.93 Patentblatt 93/18**

(84) Benannte Vertragsstaaten:
**AT BE CH DE FR GB IT LI LU NL SE**

(56) Entgegenhaltungen:
EP−A− 0 284 436    DE−A− 3 218 307
DE−A− 3 521 318    US−A− 3 906 892
US−A− 3 911 318    US−A− 4 438 368
US−A− 4 521 717    US−A− 4 897 284

**JOURNAL OF THE ELECTROCHEMICAL SOCIETY, Band 132, Nr. 6, 1985, Seiten 1460−1466, Manchester, New Hampshire, US; S.I. KIMURA et al.: "Low temperature oxidation of silicon in a microwave−discharged oxygen plasma"**

(73) Patentinhaber: **LEYBOLD AKTIENGESELLSCHAFT**
**Wilhelm−Rohn−Strasse 25, Postfach 1555**
**W−6450 Hanau am Main 1(DE)**

(72) Erfinder: **Kieser, Jörg, Dr.**
**Pautzfelder Strasse 19c**
**W−8550 Forchheim(DE)**
Erfinder: **Geisler, Michael, Dr.**
**Chatillonerstrasse 29**
**W−6480 Wächtersbach(DE)**
Erfinder: **Wilhelm, Rolf, Prof. Dr.**
**Hürnbeckstrasse 10**
**W−8000 München 45(DE)**
Erfinder: **Räuchle, Eberhard, Dr.**
**Blumenstrasse 11**
**W−7148 Remseck 5(DE)**

(74) Vertreter: **Schickedanz, Willi, Dipl.−Ing.**
**Langener Strasse 68**
**W−6050 Offenbach/Main (DE)**

---

EP 0 279 895 B1

## Beschreibung

Die Erfindung betrifft eine Einrichtung zum Herstellen eines Plasmas und zur Behandlung von Substraten darin, mit einem Mikrowellenerzeuger, einer Kammer für die Aufnahme eines Gases, einem Magnetsystem für die Erzeugung von örtlichen Elektron – Zyklotron – Resonanzen und mit einem zu beschichtenden Substrat in der Kammer.

Auf zahlreichen Gebieten der Technik ist es erforderlich, sehr dünne Schichten von reinen Stoffen auf bestimmten Gegenständen anzubringen. Beispiele hierfür sind etwa Fenster – Gläser, die mit einer dünnen Metall – oder Metalloxid – Schicht versehen werden, um aus dem Sonnenlicht bestimmte Wellenlängenbereiche auszublenden. Auch in der Halbleitertechnik werden oft auf einem Substrat dünne Schichten eines oder mehrerer Stoffe aufgebracht. Besonders wichtig ist hierbei, daß die dünnen Schichten nicht nur sehr rein sind, sondern auch sehr genau dosiert werden müssen, damit die jeweiligen Schichtdicken – und im Fall von Schichten aus chemischen Verbindungen deren Zusammensetzung – exakt reproduzierbar sind. Diese Schichtdicken liegen in der Regel zwischen zwei und einigen tausend Nanometern.

Um dünne Schichten auf Folien, Gläsern und anderen Substraten aufzubringen sind verschiedene Verfahren bekannt. Bei einem ersten Verfahren wird die dünne Schicht durch chemische oder elektrochemische Abscheidung aufgebracht, während bei einem zweiten Verfahren die Schicht durch Verdampfen im Vakuum aufgebracht wird. Beim Verdampfen ist es schwierig , große Flächen mit der gleichmäßig erforderlichen Genauigkeit und Reproduzierbarkeit mit sehr dünnen Schichten zu versehen, weshalb oft ein drittes Verfahren, das sogenannte Sputtern oder Kathodenzerstäubungs – Verfahren, herangezogen wird. Für die Abscheidung einer dünnen Schicht aus der Gasphase ist das Sputtern jedoch naturgemäß nicht geeignet.

Um einen Reinstoff oder eine chemische Verbindung aus der Gasphase abscheiden zu können, wird der Stoff bzw. die Verbindung in den Plasma – Zustand gebracht. Die im Plasma gebildeten Radikale scheiden sich auf dem Substrat ab. Für die Erzeugung eines solchen Plasmas können verschiedene Formen elektrischer Energie dienen. Beispielsweise ist es möglich, Gleichspannungen, niederfrequente Wechselspannungen oder Koronaentladungen für die Erzeugung von Plasmen zu verwenden. Besonders vorteilhaft ist die Erzeugung von Plasma durch Mikrowellen, weil hierbei u.a. keine Elektroden benötigt werden, die verschmutzen und abgetragen werden können und weil das durch Mikrowellen erzeugte Plasma eine höhere Dichte von Ionen und Radikalen aufweist und daher auch auf höherem Druck gehalten werden kann als das durch andere Verfahren erzeugte Plasma. Außerdem wird zumindest teilweise die chemische Struktur von Ausgangsmonomeren erhalten. Schließlich wird das Mikrowellen – Plasma auch für den Bau von Kaltkathoden – Ionenquellen favorisiert.

Allerdings können mittels Mikrowellen meistens nur kleine Plasmavolumina erzeugt werden, weil die Vorrichtungen, mit denen die Mikrowellenenergie dem Plasma zugeführt wird – z.B. Antennen, Wellenleiter und Hohlraumresonatoren – die Herstellung von großen Plasmavolumina nicht zulassen. Um ein Gasplasma zu erzeugen, muß die zugeführte elektrische Feldstärke die elektrische Durchbruchfeldstärke des Gases übersteigen. Da die Durchbruchfeldstärke mit steigendem Gasdruck zunimmt, sind bei hohen Drucken hohe elektrische Feldstärken erforderlich.

Es ist bereits eine Vorrichtung für die Herstellung von Plasmen mittels elektromagnetischer Strahlung bekannt, mit der hohe Feldstärken erzeugt werden (US – A – 3 814 983).

Bei dieser Vorrichtung wird eine Verzögerungsleitung, d.h. ein Mikrowellenleiter niedriger Gruppengeschwindigkeit ("slow wave structure") eingesetzt, um die elektrische Energie dem Plasma zuzuführen, wobei die Energiequelle außerhalb des Rezipienten liegt und deren elektrisches Feld durch die Rezipientenwand durchgreift. Diese Verzögerungsleitung besteht aus einer ca. 90 cm langen "halb – strahlenden" Anordnung, die im entarteten $\pi/2$ – Mode oder nahe dem entarteten $\pi/2$ – Mode arbeitet. Der Betrieb in der Nähe der Bandkante, d.h. entweder im entarteten $\pi/2$ – Mode oder im $\pi$ – Mode, führt zu besonders starken elektrischen Feldern in der Nähe der Verzögerungsleitung. Der Grund hierfür liegt in dem Umstand, daß die elektrische Feldstärke umgekehrt proportional zur Gruppengeschwindigkeit der Welle ist, die in der Nähe der Bandkante einen sehr kleinen Wert annimmt. Weiterhin fällt bei dieser Anordnung die elektrische Feldstärke mit der Entfernung senkrecht zur Ebene der Verzögerungsleitung ab. Allerdings lassen sich mit dieser Vorrichtung noch keine großvolumigen Plasmen mit einer möglichst großen, gleichförmigen Plasmazone erzeugen. Daraus folgt, daß die Niederschlagsrate von Polymerisaten über die ganze Substratbreite bei der bekannten Vorrichtung ungleichförmig ist. Überdies treten Wechselwirkungen zwischen den Wellen auf, die auf der Verzögerungsleitung, im Fensterdielektrikum und im Plasma laufen; d.h. es bilden sich schwer erfaßbare Interferenzen, die die Ausbildung der Plasmazone entsprechend negativ beeinflussen.

Um die Niederschlagsrate bei Polymerisaten zu vergleichmäßigen, ist bereits vorgeschlagen worden, bei einer Vorrichtung gemäß der US – A –

3 814 983 neben der bekannten Verzögerungsleitung auf der gleichen Seite der Substrate minde-stens eine zweite längsgestreckte Verzögerungs-leitung anzuordnen (DE − A − 31 47 986). Auch diese Anordnung der "gekreuzten Strukturen" weist jedoch den Nachteil auf, daß unmittelbar an der Innenseite des Mikrowellenfensters, wo die Mikrowelle eingespeist wird, das stärkste Plasma brennt, was zu besonders starker, unerwünschter Beschichtung dieses Fensters führt.

Es ist weiterhin eine Vorrichtung bekannt, mit der ein Plasma mittels einer Hochfrequenzwelle erzeugt wird, die in eine Wellenführung eingegeben wird, in der sich ein Glasrohr befindet, in dem das Plasma erzeugt wird (DE − A − 31 44 016). Um das Plasma − Erzeugungsrohr ist hierbei eine Spule vorgesehen, die ein Magnetfeld längs der Achse des Glasrohrs erzeugt. Bei einer Kreisfrequenz $\omega$ des Hochfrequenzfeldes und bei einer magnetischen Flußdichte B ergibt sich die Elektron − Zyklotron − Resonanzfrequenz $\omega = e \times B/m$. Bei dieser Resonanzfrequenz ist die Ankopplung der Hochfrequenzwelle an die Plasma − Elektronen besonders stark. Nachteilig ist aber auch bei dieser bekannten Vorrichtung, daß nur relativ kleine Plasma − Zonen herstellbar sind. Außerdem belegt sich das Glasrohr leicht mit aus der Gasphase abgeschiedenen Schichten.

Es ist ferner eine Mikrowellen − Plasmaquelle bekannt, die eine Vakuumkammer besitzt, welche als Entladeraum dient (US − A − 4 433 228). Die Mikrowellenenergie wird hierbei über einen Mikrowellen − Ausbreitungsweg in den Entladeraum eingespeist. Außerhalb des Entladeraums und in dem Mikrowellen − Ausbreitungsweg sind Permanentmagnete vorgesehen, die zur Führung des durch die Mikrowelle erzeugten Plasmas dienen. Die Magnetfelder dieser Permanentmagnete ermöglichen indessen keine Zyklotronenresonanz der Plasmaelektronen in einem definierten Bereich einer Behandlungskammer.

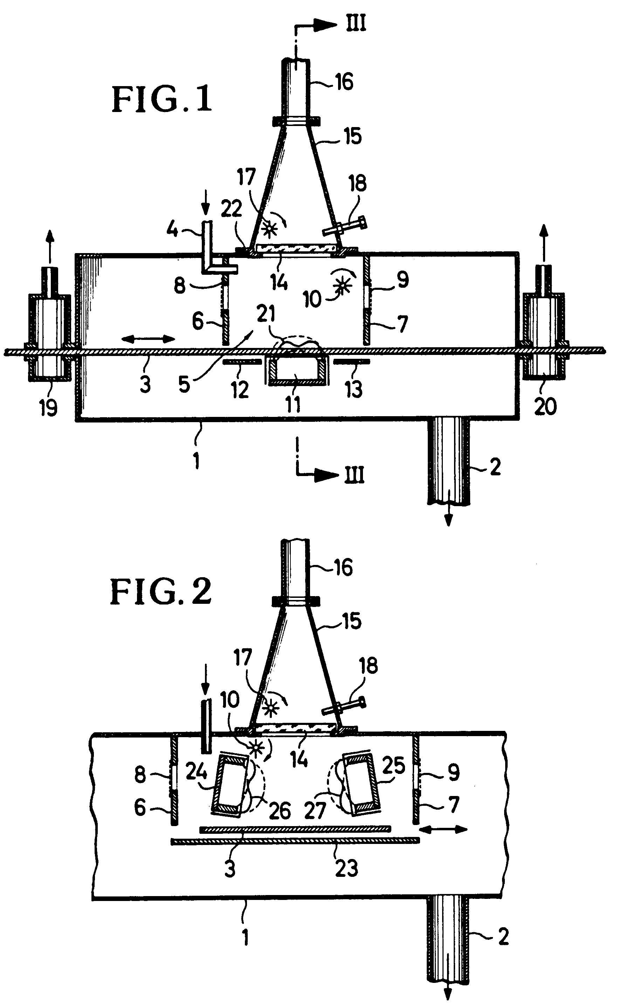

Eine andere bekannte Mikrowellen − Plasmaquelle entspricht weitgehend der Plasmaquelle gemäß DE − A − 31 44 016, wobei jedoch zusätzlich noch eine weitere Magnetspule hinter dem zu behandelnden Substrat vorgesehen ist (Kimura, Murakami, Miyake, Warabisako, Sunami und Tokuyama: "Low Temperature Oxidation of Silicon in a Microwave − Discharged Oxygen Plasma", J. Electrochem. Soc., Solid − State Science and Technology, Vol. 132, Nc. 6, 1985, S. 1460 − 1466, Fig. 1). Ein besonders interessanter Anwendungsfall für diese bekannten Plasmaquellen könnte z. B. die Beschichtung von Scheinwerferreflektoren mit Aluminium und einer plasmapolymerisierten Schutzschicht sein. Bisher wurde diese Beschichtung allerdings in sogenannten Batch − Coatern unter Verwendung eines Gleichstrom −

Plasmas durchgeführt, wobei gegebenenfalls durch Zusatz von Sauerstoff eine Hydrophylierung der Oberfläche erfolgt.

Bekannt ist auch die Abscheidung von Silan und $N_2O$ mit dem Ziel, wasserstoffhaltige $SiO_2$ − Schichten zu erzeugen. Hierbei werden in der Regel Hochfrequenz − Plasmen verwendet (vgl. D.P. Hess: J. Vac. Sci., Technol. A, 2, 1984, 244). Um die Qualität des abgeschiedenen Films im weitesten Sinne zu optimieren, sind jedoch sehr hohe Flüsse von $N_2O$ im Verhältnis zu Silan, beispielsweise von 20 : 1 bis 100 : 1, erforderlich (vgl. E.P.G.T. van de Ven, Solid State Technol. 24, 1981, 167). Typische Abscheidraten liegen im Bereich von 10 nm/min.

Der Erfindung liegt die Aufgabe zugrunde, eine Vorrichtung zu schaffen, mit der es möglich ist, einerseits ein gleichförmiges, großvolumiges Plasma zu erzeugen und andererseits das Plasma vom Mikrowellenfenster fernzuhalten.

Diese Aufgabe wird gemäß den Merkmalen des Patentanspruchs 1 gelöst.

Der mit der Erfindung erzielte Vorteil besteht insbesondere darin, daß großflächige, gleichförmige Plasmen erzeugt werden können. Ein weiterer Vorteil liegt darin, daß sich am Eintrittsfenster der Mikrowellen keine Niederschläge bilden. Diese Vorteile sind dadurch bedingt, daß das durch die Magnetsysteme hervorgerufene Magnetfeld wenigstens in Teilbereichen stark genug ist, eine sogenannte Elektron − Zyklotron − Resonanz zu ermöglichen. Hierbei wird die Tatsache ausgenutzt, daß die zum Zünden des Plasmas erforderliche elektrische Feldstärke in einem Gebiet, in dem die Elektron − Zyklotron − Resonanz erfolgen kann, erheblich kleiner ist als in einem magnetfeldfreien Bereich. Durch die Lokalisierung des für die Elektron − Zyklotron − Resonanz hinreichenden Magnetfelds läßt sich somit auch eine entspre-chende Lokalisierung der Plasmaerzeugung errei-chen. Weiterhin ist die erfindungsgemäße Einrichtung für die Beschichtung von linear − kontinuierlich bewegten Substraten besonders geeignet.

Bei der Verwendung der Erfindung zum Aufbringen einer im Bereich des sichtbaren Lichts transparenten Schutzschicht aus $SiO_2$ weist diese Schicht eine um den Faktor 40 kleinere Durchlässigkeit für Sauerstoff auf als eine herkömmliche plasma − polymerisierte Schicht.

Ausführungsbeispiele der Erfindung sind in der Zeichnung dargestellt und werden im folgenden näher beschrieben. Es zeigen:

Fig. 1      eine Prinzipdarstellung einer ersten Ausführungsform der Erfindung;

Fig. 2      eine Prinzipdarstellung einer zweiten Ausführungsform der Erfindung;

Fig. 3  eine Schnittdarstellung der in der Fig. 1 gezeigten Ausführungsform;

Fig. 4a – e  verschiedene Dauermagnetanordnungen;

Fig. 5  einen Verteiler für eine Mikrowelle;

Fig. 6  eine Anordnung zum Beschichten wickelbarer Materialien;

Fig. 7  eine Mikrowellensenderanordnung;

Fig. 8a – b  eine Dauermagnetanordnung und ein zu beschichtendes Substrat.

In der Fig. 1 ist eine Draufsicht auf eine erste Variante der Erfindung dargestellt. In einem Gehäuse 1, das über einen Stutzen 2 evakuiert werden kann, ist ein linear beweglicher Träger 3 mit einem Substrat angeordnet, das beschichtet werden soll. Die Beschichtung erfolgt mittels eines Gases das über einen Einlaßstutzen 4 in eine Kammer 5 gegeben und dort ionisiert wird. Die Kammer 5 weist Begrenzungswände aus Metall auf, von denen die Wände 6,7,12,13 in der Fig.1 erkennbar sind. Die seitlichen Wände 6,7 weisen hierbei jeweils ein mikrowellenundurchlässiges Netz 8,9 auf, das die Transparenz der Kammer 5 für einen Gaswechsel sicherstellt. In der Kammer 5 ist außerdem ein drehbarer Metallreflektor 10 vorgesehen, der die Form eines Schaufelrads besitzt. Hinter dem zu beschichtenden Substratträger 3 ist ein Magnetsystem angeordnet, das sich zwischen zwei metallischen Begrenzungswänden 12,13 befindet. Gegenüber diesem Magnetsystem 11 befindet sich ein Mikrowellenfenster 14, vorzugsweise aus Quarzglas, durch das die Mikrowellen eines Hornstrahlers 15 in die Gaskammer 5 eintreten. Dieser Hornstrahler 15 ist seinerseits mit einem Mikrowellenleiter 16 verbunden, der wiederum an einen nicht dargestellten Mikrowellensender angeschlossen ist. Die Mikrowellenleistung unmittelbar hinter dem Mikrowellenfenster 14 ist so bemessen, daß sie nicht zu spontanem Zünden des Plasmas im Fensterbereich führt.

In dem Hornstrahler 15, der auf einem Flansch 22 ruht, ist außerdem ein drehbarer Metallreflektor 17 angeordnet, dem eingeschraubte Stäbe 18 aus Metall oder aus einem Dielektrikum zur Beeinflussung der Feldverteilung gegenüberliegen.Das Gehäuse 1 ist auf beiden Seiten durch Druckkammern 19,20 abgeschlossen, die als Dichtungen für den Substratträger 3 dienen. Die Funktionsweise der in der Fig.1 dargestellten Vorrichtung ist wie folgt:

Die vom Hornstrahler 15 in Keulenform abgestrahlte Mikrowellenleistung wird in die durch die metallischen Wände 6,7,12,13 gebildete Kammer 5 gegeben und an den Wänden 6,7,12,13 bzw. an dem Substratträger 3 mehrfach reflektiert. Dadurch baut sich in der Kammer 5 eine Anzahl von stehenden Wellen mit unterschiedlicher Lage der Knoten und Bäuche auf, wenn man zunächst einmal die Absorption der Wellen durch das Plasma unberücksichtigt läßt. Die Vielzahl stehender Wellen wird auch als Multi – Mode – System bezeichnet. Durch die Überlagerung vieler Einzelschwingungen entsteht ein Wellenfeld, das wesentlich homogener ist, als die vom Hornstrahler 15 abgestrahlte Keule. Eine zusätzliche Wellen – oder Modenmischung kann durch die drehbaren Metallreflektoren 10,17 erreicht werden, die gewissermaßen als Wellenquirl arbeiten.

Für die Erfindung wesentlich ist das Magnetsystem, das im Beispiel der Fig.1 hinter dem Substratträger 3 angeordnet ist. Mit Hilfe dieses Magnetsystems wird die Elektron – Zyklotron – Resonanz erzeugt. Die durch die Mikrowellen ionisierten Gaspartikel werden aufgrund der Lorenzkraft in eine um die Magnetfeldlinien des Magnetsystems 11 gekrümmte Bahn gezogen. Die Umlauffrequenz eines geladenen Teilchens in einem homogenen Magnetfeld ist bei nicht zu großen Geschwindigkeiten von seinem Krümmungsradius unabhängig. Sie hängt nur von der spezifischen Ladung des Teilchens und der magnetischen Flußdichte ab. Es gilt also die bekannte Zylotron – Resonanz – frequenz:

$$f = \frac{e_o \cdot B}{2 \cdot \pi \cdot m}$$

worin f die Umlauffrequenz des Teilchens, $e_o$ die Ladung des Teilchens, m die Masse des Teilchens und B die magnetische Flußdichte bedeuten. Bei einer Frequenz der Mikrowelle von 2,45 GHz, die aus dem Hornstrahler 15 kommt, wird zur Erreichung der Elektron – Zyklotron – Resonanzfrequenz eine magnetische Flußdichte von B = 0,088 Vs/m$^2$ = 880 Gauss erforderlich, um solche Bedingungen in der Plasma – Kammer 5 zu schaffen , daß die Umlauffrequenz eines Elektrons um die Feldlinien des Magnetsystems 11 phasenstarr mit der anregenden Frequenz der Mikrowelle erfolgt. Die positive und negativ Halbwelle des elektrischen Feldes der Mikrowelle liegen dabei relativ zur momentanen Lage des Elektrons so, daß es immer beschleunigt wird. Auf diese Weise gelingt es, wie aus der Zyklotron – Technik bekannt, Elektronen auf sehr hohe Energien zu beschleunigen, solange man dafür sorgt, daß diese Elektronen nicht mit Restgasteilchen zusammenstoßen. Bezüglich weiterer Einzelheiten zur Wechselwirkung zwischen Plasma und elektromagnetischen Feldern wird auf die einschlägige Fachliteratur verwiesen (z.B.

Bergmann/Schäfer: Lehrbuch der Experimentalphysik, Band IV, Teil 2, Aufbau der Materie, 1975, S.1429 ff).

Bei der Erfindung kommt es nicht darauf an, Zusammenstöße der Elektronen mit Gasteilchen zu vermeiden, um die Elektronen auf ein hohes Energieniveau zu bringen; vielmehr sind solche Zusammenstöße geradezu erwünscht, um durch Stoß Radikale und Ionen zu erzeugen. Bei einem sehr häufigen Zusammenstoß von Elektronen und Gasteilchen kann man jedoch kaum mehr von einer Zyklotron−Resonanz sprechen, weil hierzu mindestens ein vollständiger Umlauf der Elektronen vorliegen muß, ehe der Stoß erfolgt. Dieser mindestens eine Umlauf wird erreicht, wenn der Druck des Gases nicht allzu hoch ist. Wie Versuche gezeigt haben, erhält man die besten Ergebnisse bei einem Gasdruck im $10^{-3}$ mbar−Bereich.

Die für die Zyklotron−Resonanz bei Ankopplung an eine Mikrowelle von 2,45 GHz erforderliche magnetische Flußdichte ist, wie erwähnt, 0,088 Tesla. Als besonders geeignet für die Erzeugung einer derartigen Flußdichte haben sich Hochleistungs−Permanentmagnete erwiesen, beispielsweise CoSm− oder Nd−Fe−B− Magnete. Verwendet man die besagten Permanentmagnete in dem Magnetsystem der Fig.1, so erhält man in dem ausgezogen dargestellten Bereich 21 eine Zyklotron−Resonanz. In diesem Bereich wird folglich das Plasma gezündet, d.h. am Fenster 14 ist kein Plasma vorhanden, das dort zu einem Niederschlag führt. Mit der Erfindung ist es also möglich, das Plasma dorthin zu legen, wo es erwünscht ist, nämlich am Substratträger 3.

Nachteilig ist hierbei jedoch für einige Anwendungsfälle, daß nur weitestgehend planare Substrate beschichtet werden können, weil sich aus praktischen Gründen die Zone 21 der Zyklotron−Resonanz nicht wesentlich weiter als etwa 20 mm oberhalb der Magnetpole erzeugen läßt.

Eine Möglichkeit, diesen Nachteil zu umgehen, ist in der Vorrichtung gemäß Fig.2 gezeigt. In dieser Vorrichtung wird vor dem dargestellten Substratträger 3 ein Plasma erzeugt, wodurch auch ausgeprägte dreidimensionale Substrate beschichtet werden können. Die Magnetanordnung besteht hier aus zwei Systemen 24 und 25, die symmetrisch zu einer gedachten Gerade längs der Achse des Wellenleiters 16 und des Hornstrahlers 15 angeordnet sind. Hierbei entstehen zwei Zyklotron−Resonanzbereiche 26,27, die als Zündzonen für das Plasma dienen. Die beiden metallischen Begrenzungswände 12,13 gemäß Fig.1 sind in der Fig.2 durch eine einzige Begrenzungswand 23 ersetzt.

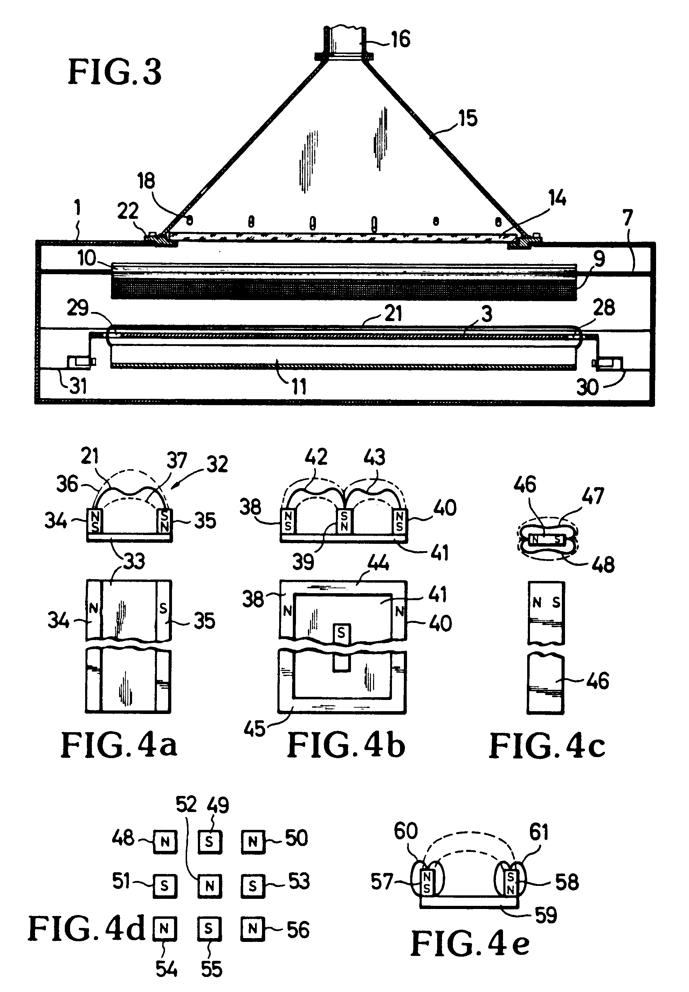

In der Fig.3 ist die Vorrichtung der Fig.1 als Schnitt III−III dargestellt.Man erkennt hierbei, daß mehrere Stäbe 18 verschieden tief in den Hornstrahler 15 eingeschraubt sind. Mit diesen Stäben 18 kann das Mikrowellenfeld in dem Sinne beeinflußt werden, daß es gezielt verbogen wird. Das Netz 9 ist jetzt deutlich neben dem Mikrowellen−Verwirbler 10 sichtbar. In dem Substratträger 3 sind Durchbrüche 28,29 vorgesehen, durch die die gezündete Plasmafront 21 greift. Die Halterung des Substratträgers 3 erfolgt über die Bügel 30,31.

Die Figuren 4a bis 4e zeigen verschiedene Dauermagnetanordnungen, die für das Magnetsystem 11 geeignet sind. Die im oberen Bereich der Figuren gezeigten Darstellungen sind Profildarstellungen, während die darunter gezeigten Darstellungen Draufsichten sind.

In der Fig.4a ist ein U−förmiger Dauermagnet 32 dargestellt, der zwei über ein Joch 33 miteinander verbundene Schenkel aufweist. Der Bereich der Zyklotron−Resonanz ist hierbei mit 21 bezeichnet. Die gestrichelt angedeuteten Linien 36,37 stellen magnetische Feldlinien dar, auf denen keine Zyklotron−Resonanz stattfindet. Die Schenkel 34,35 sind Stabmagnete mit jeweils einem Nord− und einem Südpol, wobei die Anordnung von Nord− und Südpol beim Schenkel 34 derjenigen des Schenkels 35 entgegengesetzt ist. Das Magnetfeld der Anordnung gemäß Fig.4a übt eine vergleichmäßigende Wirkung auf die Dicke der niedergeschlagenen Stoff−Schicht in Längsrichtung auf, was auf einer kooperativen Driftbewegung der Elektronen zu beruhen scheint, wie sie aus der Magnetron−Technik bekannt ist. Es fehlt die vom Sputter−Magnetron bekannte $\vec{E} \times \vec{B}$ − Bewe−gung, weil kein zum $\vec{B}$−Feld senkrechtes kon−stantes $\vec{E}$−Feld vorhanden ist. Es kann aber eine Driftbewegung in Längsrichtung der Magnetfeldanordnung angenommen werden, die auf die starke Abnahme des $\vec{B}$−Feldes oberhalb und unterhalb der Zyklotron−ResonanzFläche zurückgeht. Die resultierende Kraft ist dann $\vec{F} \sim \nabla \vec{B} \times \vec{B}$. Diese resultierende Kraft bewirkt außerdem, daß das Plasma vor einem Substratträger, der die magnetfelderzeugende Vorrichtung abdeckt, nur dann gut brennt, wenn der Substratträger im Bereich der Stirnseite des Magnetsystems Schlitze aufweist, wie sie in der Fig.3 dargestellt sind.

Eine andere Dauermagnetanordnung ist in der Fig.4b gezeigt. Dort sind drei Stabmagnete 38,39,40 mit abwechselnden Nord− und Südpolen nebeneinander auf einem gemeinsamen Joch 41 angeordnet. Hierdurch erhält man eine Linearisierung der Zyklotron−Resonanz−Zone, weil nunmehr zwei kleine Resonanzbögen 42,43 aneinander anschließen. Wie man aus der unteren Darerkennt, sind die beiden äußeren Stabmagnete 38,40 über Schenkel 44,45 miteinander verbunden. Die Anordnung der Fig.4b wird auch als "Race−Track"−Anordnung bezeichnet.

Die Fig.4c zeigt einen einfachen Stabmagneten 46, der zwei Zyklotron–Resonanzbereiche 47,48 ausbildet. Aus der unteren Darstellung ist ersichtlich, daß Nord– und Südpol einen relativ kleinen Abstand voneinander haben, verglichen mit der Länge von Nord– bzw. Südpol insgesamt. Allgemein wird man eine möglichst große, flächenmäßige Ausbildung des 0,088 Tesla–Bereichs anstreben. Dies erfordert jedoch eine Magnetmasse, die etwa um den Faktor 3 über derjenigen für ein herkömmliches Magnetron–Magnetfeld liegt.

Fig.4d zeigt eine sogenannte Matrixanordnung von Magneten, bei der insgesamt neun Dauermagnete 48–56 in gleichem Abstand nebeneinander und mit abwechselnden Polen angeordnet sind.

In der Fig.4e ist ein Dauermagnetsystem gezeigt, das demjenigen der Fig.4a ähnlich ist. Anders als dort bilden jedoch die über das Joch 59 verbundene Dauermagnete 57,58 eine Zyklotron–Resonanzzone 60,61 um die eigene Nordpol/Südpol–Richtung aus. Es handelt sich hierbei um ein mit einfacher Bestückung ausgestattetes Magnetsystem, wie es für Sputter–Magnetrons verwendet wird, bei dem die Elektron–Zyklotron–Resonanz um die Einzelmagnete stattfindet.
Neben seiner Funktion, für eine Resonanz zu sorgen, kommt den Magnetieldern in gleicher Weise wie beim normalen magnetischen Einschluß die Funktion der magnetischen Falle zu; d.h. das Plasma wird auf den Bereich des Magnetfelds konzentriert.

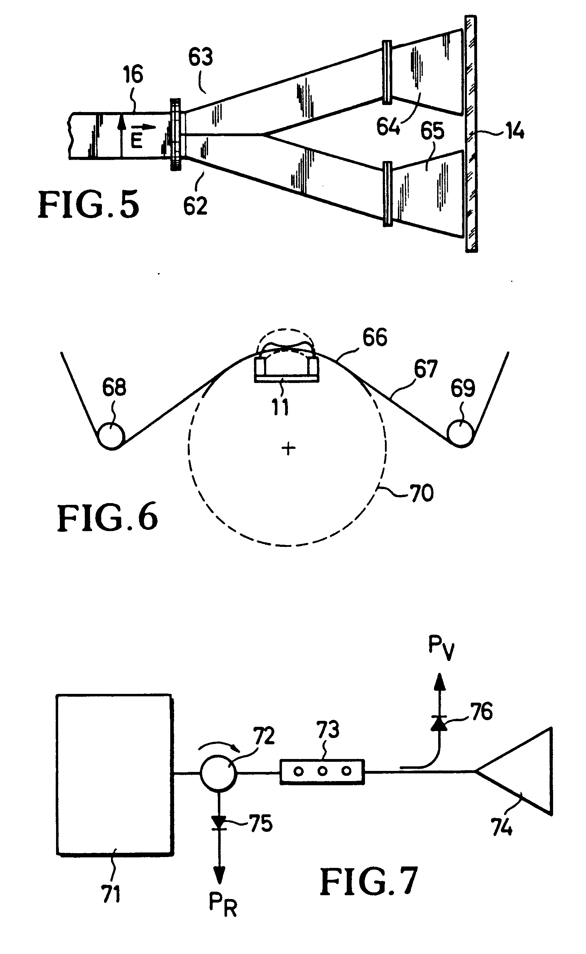

Die Fig.5 zeigt eine Vorrichtung, bei der ein Wellenleiter 16 in zwei Teilleiter 62,63 aufgeteilt ist. Jeder dieser Teilleiter 62,63 endet in einem eigenen Hornstrahler 64,65. Auf entsprechende Weise läßt sich eine Vielzahl von Hornstrahlern realisieren, deren kombiniertes Wellenfeld wesentlich uniformer ist als das eines einzelnen Hornstrahlers.

In der Fig.6 ist im Prinzip dargestellt, auf welche Weise wickelbare Materialien mit der erfindungsgemäßen Vorrichtung beschichtet werden können.Auf die Darstellung der Einspeisung der Mikrowelle wurde hierbei verzichtet. Es ist nur das Magnetsystem 11 dargestellt sowie ein Teil einer Walzen – Führung für das wickelbare Material 67, das über Rollen 68,69 geführt wird. Die Walze 66 erstreckt sich hierbei über den Umfang eines angedeuteten Kreises 70.

Die Fig.7 zeigt die prinzipielle Anordnung der Mikrowellensendeanlage, die bei der Erfindung zur Anwendung kommt. Diese weist einen Mikrowellensender 71 auf, der über einen Zirkulator 72 und einen Drei–Stab–Tuner 73 mit einem Hornstahler 74 verbunden ist. An den Zirkulator ist eine Einrichtung 75 für die Messung der reflektierten Leistung angeschlossen. Diese Einrichtung ist lediglich durch eine Diode symbolisiert. Zwischen den Drei–Stab–Tuner 73 und den Hornstrahler 74 ist eine weitere Meßeinrichtung 76 angeschlossen, mit der die Vorwärtsleistung gemessen wird. Auch diese Meßeinrichtung 76 ist lediglich durch eine Diode symbolisiert.

Die Einstrahlung der Mikrowellenleistung kann aus einem einfachen Hohlleiter ohne Abschluß erfolgen, denn bei diesem tritt einseitig ein gewisser Teil der Mikrowellenleistung aus. Durch den abrupten Übergang tritt jedoch teilweise Reflektion der Mikrowellenleistung in den Hohlleiter auf. Eine fast vollständige Abstrahlung kann man durch allmählichen Übergang erreichen, etwa als gleichmäßige Erweiterung des Hohlleiters in Richtung auf ein Horn hin. Im vorliegenden Fall, wo eine Reflexion von 5 bis 10% der abgestrahlten Leistung noch akzeptabel ist, reicht eine näherungsweise Ausbildung der Form, wie sie in den Figuren 1,2,3 dargestellt ist, vollständig aus.

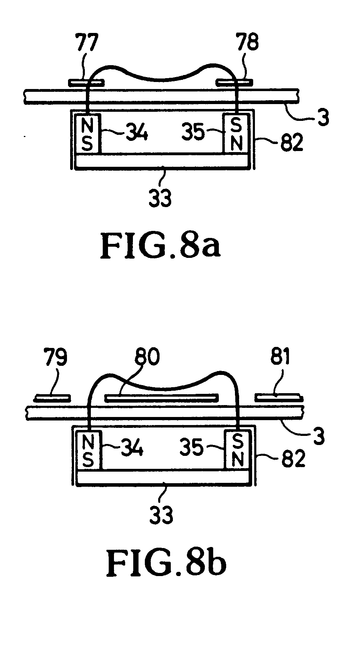

In den Figuren 8a und 8b sind zusätzliche Blenden 77,78 bzw. 79,80,81 vorgesehen, mit denen erreicht werden kann, daß entweder ionenunterstützt abgeschieden wird (Fig.8b) oder daß eine Abscheidung ohne simultanen Ionenbeschuß erfolgt (Fig.8a). Das Magnetsystem ist hier, wie auch bei den Magnetsystemen der früheren Figuren, mit einer Umhüllung 82 versehen. Bei hinreichend vielen Umläufen der Elektronen zwischen den Stößen im Bereich der Elektron–Zyklotron–Resonanzfrequenz können die Elektronen hohe kinetische Energien aufnehmen. Da das Magnetfeld ihrer Bewegung in Richtung der Feldlinien keinen Widerstand entgegensetzt, ist bei den Ausführungsformen gemäß den Figuren 1 und 3 der Bereich des Substrats, in dem die Feldlinien durchstoßen, entsprechendem Elektronenbeschuß ausgesetzt, was über die resultierende negative Aufladung, die sogenannte "self–bias", zu entsprechendem Beschuß dieses Bereichs mit positiven Ionen führt. Durch die Blenden kann dieser Ionenbeschuß gesteuert werden.

Die in den Figuren dargestellten Ausführungsformen der Erfindung können auf vielfältige Weise variiert werden. Beispielsweise ist die Lage der Ebene des Mikrowellenfensters 14 relativ zur Substratebene nicht auf Parallelität beschränkt, wie sie in den Figuren 1–3 dargestellt ist. Vielmehr kann die beschriebene Ausbildung eines Multi–Moden–Zustands in der Kammer 5 durch eine beliebige Lage des Mikrowellenfensters 14 erreicht werden. Wesentlich ist nur die Zuordnung der zu behandelnden Substratoberfläche zum Bereich der Elektron–Zyklotron–Resonanz.

Auch die magnetischen Polflächen brauchen nicht, wie in den Figuren 4a,b,c, d,e dargestellt, in einer Ebene zu liegen. Darüber hinaus kann auch eine Tiefenstaffelung in der Weise vorgenommen werden, daß alle Nordpolflächen in einer ersten Ebene und alle Südpolflächen in einer davon verschiedenen zweiten Ebene liegen. Auch die Abstände der erwähnten Nord- und Südpole können variabel gehalten werden.

Als besonders vorteilhaft hat sich die Verwendung der Erfindung für das Aufbringen einer im Bereich des sichtbaren Lichts transparenten Schutzschicht aus SiO$_x$ erwiesen, wobei x zwischen 1 und 2 liegt. Hierbei wird ein gasförmiger Siliziumwasserstoff unter Zufuhr von Sauerstoff oder einer sauerstoffhaltigen Verbindung in einer Plasmaentladung zersetzt und das gebildete SiO$_x$ auf einem ein Substrat bildenden Vorderflächenspiegel niedergeschlagen.

Zusätzlich kann noch ein gasförmiges Monomer aus der Gruppe der Siliziumkohlenwasserstoffe in die Plasmaentladung eingeführt werden.

Es hat sich gezeigt, daß mit der Plasmapolymerisation im Mikrowellenplasma gute Schutzschichten mit sehr hoher Niederschlagsrate abgeschieden werden können. Hierdurch ist es z. B. möglich, bei der Herstellung von Scheinwerferreflektoren, die eine Aluminiumschicht und eine Schutzschicht gegen Korrosion besitzen, beide Schichten in einer Maschine aufzubringen, die in einem ersten Schritt die Aluminium-Schicht durch Aufsputtern aufbringt und in einem zweiten Schritt die Schutzschicht durch die erwähnte Plasmapolymerisation abscheidet.

Im Zusammenhang mit der Abscheidung von wasserstoffhaltigem Siliziumdioxid im Mikrowellenplasma aus Silan und Lachgas (N$_2$O) wurden quantitative Messungen zur Permeabilität einer erfindungsgemäß gewonnenen Schutzschicht im Vergleich zur Permeabilität konventioneller plasma-polymerisierter Schichten durchgeführt. Als Testgas wurde Sauerstoff benutzt. Hierbei hat sich gezeigt, daß die erfindungsgemäß aufgebrachten SiO$_2$-Schichten eine um den Faktor 40 kleinere Durchlässigkeit für Sauerstoff aufwiesen als herkömmlich hergestellte Schichten gleicher Dicke.

Mit der Erfindung ist es möglich, dichte Schichten mit guter Stöchiometrie bereits bei Verhältnissen von N$_2$O/Silan > 2 zu erhalten, d. h. es wird nicht der bei den bekannten Verfahren erforderliche große N$_2$O-Gasfluß benötigt, der zwar sehr viel Pumpkapazität benötigt, aber keineswegs zur Erhöhung der Niederschlagsrate beiträgt. Die Flußrate für N$_2$O, die bei der Erfindung erforderlich ist, liegt etwa um den Faktor 10 bis 50 unter den bisher bekannten Flußraten. Außerdem ist die mit der Erfindung erreichte Ausscheidungsrate mit ca. 10nm/s mindestens um den Faktor 50 größer als die bisher bekannten Ausscheidungsraten.

Beispiel

Eine Anlage zur Beschichtung im Mikrowellenplasma wird zunächst auf einen Restgasdruck von < 1 . 10$^{-4}$ mbar evakuiert. Anschließend wird Silangas (SiH$_4$) mit einem solchen Gasfluß eingelassen, daß sich ein Silan-Partialdruck von 2 . 10$^3$ mbar einstellt. Sodann wird zusätzlich Lachgas (N$_2$O) bis zum Erreichen eines stationären Totaldrucks von 6 . 10$^{-3}$ mbar eingelassen. Daraufhin wird Mikrowellenleistung in die Anlage eingespeist, und zwar durch ein für Mikrowellen durchlässiges Fenster. Die Leistungsdichte beträgt hierbei ca. 3 W pro cm$^2$ Fensterfläche. In einem Magnetfeld, das sich innerhalb der Anlage befindet, wird anschließend ein Plasma erzeugt.

Ein auf einem Substratträger befestigter, frisch mit Aluminium bedampfter Scheinwerferreflektor wird mit einer solchen Geschwindigkeit durch die Plasmazone gefahren, daß jeder Punkt der Reflektoroberfläche eine Verweilzeit im Plasma von 5 Sekunden hat. Dies führt zu einer abgeschiedenen Schicht mit einer mittleren Dicke von 40 nm auf dem Reflektor, was einer mittleren Abscheiderate von 8 nm/s entspricht. Eine Untersuchung dieser Schicht mit Hilfe der Photoelektronen-Spektroskopie ergibt ein Verhältnis von Si : O von ca. 1 : 1, 8, d. h. gute Stöchiometrie.

Zum Test der Schutzwirkung der aufgebrachten Schicht wird eine 0,2 % NaOH-Lösung aufgebracht und die Zeit bis zur Auflösung der Al-Schicht gemessen. Sie ist für die beschriebene Schicht größer als drei Stunden.

**Patentansprüche**

1. Einrichtung zum Herstellen eines Plasmas und zur Behandlung von Substraten darin, mit
   a) einem Mikrowellenerzeuger;
   b) einer Kammer (5) für die Aufnahme eines Gases;
   c) einem Magnetsystem (11) für die Erzeugung von örtlichen Elektronen-Zyklotron-Resonanzen und
   d) einem zu beschichtendem Substrat (3) in der Kammer (5),
   **dadurch gekennzeichnet, daß**
   e) die Kammer (5) durch metallische Wände (6, 7, 12, 13) gebildet ist und ein Eintrittsfenster (14) aufweist, das Mikrowellen durchläßt und für Gase undurchdringlich ist;
   f) eine Vorrichtung (10) vorgesehen ist, welche innerhalb der Kammer (5) ein überall nahezu gleichförmiges Miltrowellenfeld bewirkt;
   g) das Magnetsystem (11), dessen Feldstärke in Verbindung mit dem Mikrowellenfeld und dem in der Kammer (5) befindlichen Gas eine Elektronen – Zyklotron – Resonanz in der Kammer (5) erzeugen kann, derart beweglich ist, daß der Ort einer Elektronen – Zyklotron – Resonanz in der Kammer (5) örtlich frei wählbar ist und einen vorgegebenen Abstand vom Substrat (3) hat.

2. Einrichtung nach Anspruch 1, dadurch gekennzeichnet, daß das Substrat (3) relativ zu dem Magnetsystem (11) beweglich ist.

3. Einrichtung nach Anspruch 1, dadurch gekennzeichnet, daß das Eintrittsfenster (14) aus Quarzglas besteht.

4. Einrichtung nach Anspruch 1, dadurch gekennzeichnet, daß das Eintrittsfenster (14) an einen Hornstrahler (15) anschließt, der mit einem Mikrowellenleiter (16) verbunden ist, der seinerseits an einen Mikrowellensender (71) gekoppelt ist.

5. Einrichtung nach Anspruch 1, dadurch gekennzeichnet, daß das zu beschichtende Substrat (3) vor den hinteren Wänden (12,13) der Kammer (5) angeordnet ist, welche dem Eintrittsfenster gegenüberliegen.

6. Einrichtung nach Anspruch 1, dadurch gekennzeichnet, daß das Magnetsystem (11) auf derjenigen Seite des zu beschichtenden Substrats (3) angeordnet ist, die vom Eintrittsfenster (14) abgewendet ist, und daß die Bedingung für die Elektron – Zyklotron – Resonanz vor der Oberfläche des Substrats (3) erfüllt ist.

7. Einrichtung nach Anspruch 1, dadurch gekennzeichnet, daß das Magnetsystem (24,25) zwischen Eintrittsfenster (14) und zu beschichtendem Substrat (3) angeordnet ist.

8. Einrichtung nach Anspruch 7, dadurch gekennzeichnet, daß zwei Magnetsysteme (24,25) vorgesehen sind, die bezüglich einer gedachten Ebene, die senkrecht auf dem zu beschichtenden Substrat (3) steht, spiegelsymmetrisch angeordnet sind.

9. Einrichtung nach Anspruch 8, dadurch gekennzeichnet, daß die Normalen der beiden Magnetsysteme (24,25) einen Winkel einschließen.

10. Einrichtung nach Anspruch 1, dadurch gekennzeichnet, daß die Kammer (5) Netzöffnungen (8,9) für einen Gaswechsel besitzt.

11. Einrichtung nach Anspruch 1, dadurch gekennzeichnet, daß das Magnetsystem (11; 24,25) wenigstens einen Dauermagneten enthält.

12. Einrichtung nach Anspruch 1, dadurch gekennzeichnet, daß die Kammer (5) wenigstens einen Mikrowellen – Verwirbler (10) enthält.

13. Einrichtung nach Anspruch 1, dadurch gekennzeichnet, daß sich der Bereich, in dem die Elektron – Zyklotron – Resonanz auftritt, mindestens 10 mm vor den Polflächen des Magnetsystems (11,24,25) befindet.

14. Einrichtung nach Anspruch 1, dadurch gekennzeichnet, daß die Kammer (5) wenigstens eine Gaszuführungsöffnung (4) aufweist.

15. Einrichtung nach Anspruch 4, dadurch gekennzeichnet, daß im Hornstrahler (15) wenigstens ein Mikrowellen – Verwirbler (17) vorgesehen ist.

16. Einrichtung nach den Ansprüchen 12 und 15, dadurch gekennzeichnet, daß der Mikrowellen – Verwirbler (10,17) als Schaufelrad ausgebildet und um eine Achse drehbar ist, wobei die einzelnen Schaufeln eine metallische Oberfläche besitzen.

17. Einrichtung nach Anspruch 1, dadurch gekennzeichnet, daß sich die durch metallische Wände (6,7,12,13) gebildete Kammer (5) innerhalb eines evakuierbaren Gehäuses (1) befindet.

18. Einrichtung nach Anspruch 17, dadurch gekennzeichnet, daß das evakuierbare Gehäuse (1) Öffnungen aufweist, durch die ein beispielsweise bandförmiges Substrat (3) nach außen transportiert werden kann, und daß an diesen Öffnungen Dichtungsmittel (19,20) vorgesehen sind.

19. Einrichtung nach Anspruch 4, dadurch gekennzeichnet, daß an wenigstens einer Wand des Hornstrahlers (15) eine Vorrichtung (18) vorgesehen ist, mit der sich die räumliche Verteilung des Mikrowellenfeldes beeinflussen läßt.

20. Einrichtung nach Anspruch 19, dadurch gekennzeichnet, daß die Vorrichtung (18) aus mehreren in die Wand des Hornstrahlers (15) einschraubbaren Stäben aus Metall oder aus einem Dielektrikum besteht.

21. Einrichtung nach Anspruch 1, dadurch gekennzeichnet, daß der Substratträger (3) Durchbrechungen (28,29) aufweist, durch welche die Front (21) der Elektron-Zyklotron-Resonanz auf das Magnetsystem (11) durchgreifen kann.

22. Einrichtung nach Anspruch 11, dadurch gekennzeichnet, daß ein Dauermagnetsystem (32) ein Joch (33) mit zwei Schenkeln (34,35) aufweist, von denen der eine Schenkel (34) mit seinem Südpol und der andere Schenkel (35) mit seinem Nordpol auf dem Joch (33) sitzt.

23. Einrichtung nach Anspruch 11, dadurch gekennzeichnet, daß das Dauermagnetsystem drei Schenkel (38,39,40) besitzt, von denen die beiden äußeren Schenkel (38,40) über Stege (44,45) miteinander verbunden sind und den inneren Schenkel (31) einschließen.

24. Einrichtung nach Anspruch 11, dadurch gekennzeichnet, daß das Dauermagnetsystem n Einzelmagnete (48–56) enthält, die äquidistant angeordnet sind und jeweils Polenden besitzen, die sich bezüglich der Polarität von den Polenden der jeweils benachbarten Einzelmagnete unterscheiden.

25. Einrichtung nach Anspruch 1, dadurch gekennzeichnet, daß das Eintrittsfenster (14) mit n Hornstrahlern (64,65) in Verbindung steht, die über Verteiler (62,63) mit Mikrowellen versorgt werden.

26. Einrichtung nach Anspruch 1, dadurch gekennzeichnet, daß der Mikrowellenerzeuger einen Mikrowellensender (71) aufweist, der über einen Zirkulator (72) und einen Tuner (73) mit einem Hornstrahler (74) in Verbindung steht.

27. Einrichtung nach Anspruch 26, dadurch gekennzeichnet, daß zwischen dem Mikrowellensender (71) und dem Hornstrahler (74) eine Meßeinrichtung (75) zur Messung der reflektierten Leistung sowie eine Meßeinrichtung (76) zur Messung der Vorwärtsleistung vorgesehen ist.

28. Einrichtung nach den Ansprüchen 11,22,23, und 24, dadurch gekennzeichnet, daß die Polaustrittsflächen der einzelnen Magnete (z.B. 48–56) sowohl in Tiefenrichtung als auch im gegenseitigen Abstand variabel sind.

29. Einrichtung nach Anspruch 6, dadurch gekennzeichnet, daß die Bereiche des Substrats (3), durch die die Magnetfeldlinien hindurchtreten, eine Abschirmung (77,78) aufweisen.

30. Einrichtung nach Anspruch 6, dadurch gekennzeichnet, daß das Substrat (3) von einer Abschirmung (79,80,81) abgedeckt ist, daß der Bereich des Magnetfeldes, in dem die Elektron-Zyklotron-Resonanz auftritt, außerhalb der Abschirmung liegt und daß nur diejenigen Bereiche, in denen das Magnetfeld durch das Substrat tritt, offen bleiben.

31. Einrichtung nach Anspruch 1, dadurch gekennzeichnet, daß sich in der Kammer (5) wenigstens ein Teil einer Walze (66) zur Beschichtung von wickelbarem Material (67) befindet, wobei ein Magnetsystem (11) so angeordnet ist, daß der Bereich der Elektron-Zyklotron-Resonanz außerhalb der Walze (66) und oberhalb des Kontaktbereichs zwischen Substrat und Walze liegt.

32. Einrichtung nach Anspruch 1, dadurch gekennzeichnet, daß der Prozeßdruck des Gases zwischen $1 \times 10^{-4}$ und $1 \times 10^{-2}$ mbar liegt.

33. Verwendung einer Vorrichtung nach mindestens einem der Ansprüche 1 bis 32 für ein Verfahren zum Aufbringen einer im Bereich sichtbaren Lichts transparenten Schutzschicht aus $SiO_x$, wobei x zwischen 1 und 2 liegt, durch Zersetzung eines gasförmigen Siliziumwasserstoffs unter Zufuhr von Sauerstoff oder einer sauerstoffhaltigen Verbindung in einer Plasmaentladung und Niederschlagen des dadurch gebildeten $SiO_x$ auf einem ein Substrat bildenden Vorderflächenspiegel eines Scheinwerforeflektors.

34. Verwendung nach Anspruch 33, dadurch gekennzeichnet, daß zusätzlich ein gasförmiges Monomer aus der Gruppe der Siliziumkohlenwasserstoffe in die Plasmaentladung eingeführt wird.

**Claims**

1. Appliance for the production of a plasma and for the processing of substrates therein, with
   (a) a microwave generator;
   (b) a chamber (5) for receiving a gas;
   (c) a magnetic system (11) for generating local electron cyclotron resonances and
   (d) a substrate (3) inside the chamber (5) on which a coating is to be applied,
   **characterised in that**
   (e) the chamber (5) is formed by metallic walls (6, 7, 12, 13) and has an input window (14) which permits microwaves to pass through and is impermeable to gases;

(f) a device (10) is provided which produces an almost uniform microwave field at all points inside the chamber (5);

(g) the magnetic system (11), whose field strength can generate an electron cyclotron resonance in the chamber (5) in combination with the microwave field and the gas in the chamber (5) is movable in such a way that the position of an electron cyclotron resonance in the chamber (5) can be freely selected and is at a given distance from the substrate (3).

2. Appliance as described in Claim 1, characterised in that the substrate (3) is movable relative to the magnetic system (11).

3. Appliance as described in Claim 1, characterised in that the input window (14) consist of quartz glass.

4. Appliance as described in Claim 1, characterised in that the input window (14) connects with a horn radiator (15) linked to a microwave guide (16) which in turn is coupled to a microwave transmitter (71).

5. Appliance as described in Claim 1, characterised in that the substrate to be coated (3) is arranged in front of the rear walls (12, 13) of the chamber (5), which are situated opposite the input window.

6. Appliance as described in Claim 1, characterised in that the magnetic system (11) is arranged on the side of the substrate to be coated (3) which faces away from the input window (14), and that the condition for electron cyclotron resonance is satisfied in front of the surface of the substrate (3).

7. Appliance as described in Claim 1, characterised in that the magnetic system (24, 25) is arranged between the input window (14) and the substrate to be coated (3).

8. Appliance as described in Claim 7, characterised in that two magnetic systems (24, 25) are provided, arranged in mirror symmetry with respect to an imaginary plane standing perpendicular to the substrate (3) to be coated.

9. Appliance as described in Claim 8, characterised in that the normals of the two magnetic systems (24, 25) form an angle.

10. Appliance as described in Claim 1, characterised in that the chamber (5) has grid apertures (8, 9) for gas-exchange purposes.

11. Appliance as described in Claim 1, characterised in that the magnetic system (11; 24, 25) contains at least one permanent magnet.

12. Appliance as described in Claim 1, characterised in that the chamber (5) contains at least one microwave turbulator (10).

13. Appliance as described in Claim 1, characterised in that the zone in which the electron cyclotron resonance occurs is at least 10 mm in front of the pole faces of the magnetic system (11, 24, 25).

14. Appliance as described in Claim 1, characterised in that the chamber (5) has at least one gas supply inlet (4).

15. Appliance as described in Claim 4, characterised in that at least one microwave turbulator (17) is provided in the horn radiator (15).

16. Appliance as described in Claims 12 and 15, characterised in that the microwave turbulator (10, 17) is shaped like a paddle wheel and can be rotated round an axis, the individual paddles having a metal surface.

17. Appliance as described in Claim 1, characterised in that the chamber (5) formed by metallic walls (6, 7, 12, 13) is located inside an evacuable casing (1).

18. Appliance as described in Claim 17, characterised in that the evacuable casing (1) has orifices through which, for example, a substrate (3) in the form of a ribbon can be moved outwards, and in that means (19, 20) are provided for sealing these orifices.

19. Appliance as described in Claim 4, characterised in that on at least one wall of the horn radiator (15) a device (18) is provided which enables the spatial distribution of the microwave field to be adjusted.

20. Appliance as described in Claim 19, characterised in that the device (18) consists of several metal or dielectric rods screwed into the wall of the horn radiator (15).

21. Appliance as described in Claim 1, characterised in that the substrate carrier (3) has perforations (28, 29) through which the front (21) of the electron cyclotron resonance can reach the magnetic system (11).

22. Appliance as described in Claim 11, charac‐terised in that a system of permanent magnets (32) has a yoke (33) with two arms (34, 35), of which one arm sits on the yoke (33) with its south pole and the other with its north pole.

23. Appliance as described in Claim 11, charac‐terised in that the permanent magnetic system has three arms (38, 39, 40), of which the two outer arms (38, 40) are linked to each other by bridges (44, 45) and enclose the inner arm (31).

24. Appliance as described in Claim 11, charac‐terised in that the permanent magnetic system has n individual magnets (48‐56) which are arranged at equal distance from each other and each of which has pole ends which differ in polarity from those of the pole ends of the adjacent individual magnets.

25. Appliance as described in Claim 1, charac‐terised in that the input window (14) is linked to n horn radiators (64, 65) which are supplied with microwaves via distributors (62, 63).

26. Appliance as described in Claim 1, charac‐terised in that the microwave generator has a microwave transmitter (71) connected through a circulator (72) and a tuner (73) to a horn radiator (74).

27. Appliance as described in Claim 26, charac‐terised in that between the microwave trans‐mitter (71) and the horn radiator (74) a mea‐suring device (75) is provided for measuring the reflected energy and also a measuring device (76) for measuring the forward energy.

28. Appliance as described in Claims 11, 22, 23 and 24, characterised in that the polar effective faces of the individual magnets (e.g. 48‐56) are variable both in height and with respect to the distance between them.

29. Appliance as described in Claim 6, charac‐terised in that those areas of the substrate (3) penetrated by the lines of magnetic flux are provided with screening (77, 78).

30. Appliance as described in Claim 6, charac‐terised in that the substrate (3) is covered by a screening (79, 80, 81), that the area of the magnetic field in which the electron cyclotron resonance occurs is outside the screening and that only those areas in which the magnetic field penetrates the substrate remain open.

31. Appliance as described in Claim 1, charac‐terised in that there is in the chamber (5) at least one part of a cylinder (66) for the coating of coilable material (67), whereby a magnetic system (11) is so arranged that the area of electron cyclotron resonance lies outside the cylinder (66) and above the contact zone be‐tween substrate and cylinder.

32. Appliance as described in Claim 1, charac‐terised in that the operational pressure of the gas is between $1 \times 10^{-4}$ and $1 \times 10^{-2}$ mbar.

33. Use of an appliance as described in at least one of Claims 1 to 32 in a procedure for the deposition of a protective coating, transparent in the range of visible light, of $SiO_x$, where x is between 1 and 2, by decomposition of a gas‐eous silicon hydride under a supply of oxygen or an oxygen‐containing compound in a plasma discharge and precipitation of the $SiO_x$ thus formed on a front‐facing headlight re‐flector forming a substrate.

34. Use as described in Claim 33, characterised in that a gaseous monomer from the silicohydrocarbon group is also introduced into the plasma discharge.

**Revendications**

1. Dispositif de fabrication d'un plasma et de traitement de substrats comportant
   a) un générateur de micro‐ondes ;
   b) une chambre (5) destinée à recueillir un gaz ;
   c) un système magnétique (11) pour pro‐duire des résonances locales de cyclotron pour électrons et
   d) un substrat (3) à recouvrir dans la chambre (5),
   caractérisé en ce que
   e) la chambre (5) est formée par des parois métalliques (6, 7, 12, 13) et comporte une fenêtre d'entrée (14) qui laisse passer les micro‐ondes et ne laisse pas passer les gaz ;
   f) il est prévu un dispositif (10) qui produit à l'intérieur de la chambre (5) un champ de micro‐ondes pratiquement uniforme par‐tout ;
   g) le système magnétique (11) dont l'in‐tensité de champ en liaison avec le champ à micro‐ondes et le gaz se trouvant dans la chambre (5), peut produire une résonance de cyclotron pour électrons dans la chambre (5), est déplaçable de manière qu'il soit possible de sélectionner librement, localement, l'emplacement d'une résonance de cyclotron pour électrons dans la chambre (5) et qu'il se situe à une distance donnée du substrat (3).

2. Dispositif selon la revendication 1, caractérisé en ce que le substrat (3) est déplaçable par rapport au système magnétique (11).

3. Dispositif selon la revendication 1, caractérisé en ce que la fenêtre d'entrée (14) est en verre au quartz.

4. Dispositif selon la revendication 1, caractérisé en ce que la fenêtre d'entrée (14) se raccorde à un émetteur de rayonnement en cornet (15), qui est relié à un guide de micro-ondes (16) qui de son côté est accouplé à un émetteur de micro-ondes (71).

5. Dispositif selon la revendication 1, caractérisé en ce que le substrat (3) à recouvrir est placé devant les parois arrière (12, 13) de la chambre (5) qui font face à la fenêtre d'entrée.

6. Dispositif selon la revendication 1, caractérisé en ce que le système magnétique (11) est placé sur le côté du substrat (3) à recouvrir qui est opposé à la fenêtre d'entrée (14) et en ce que la condition pour la résonance de cyclotron pour électrons est remplie par la surface du substrat (3).

7. Dispositif selon la revendication 1, caractérisé en ce que le système magnétique (24, 25) est placé entre la fenêtre d'entrée (14) et le substrat (3) à recouvrir.

8. Dispositif selon la revendication 7, caractérisé en ce qu'il est prévu deux systèmes magnétiques (24, 25) qui sont placés dans une symétrie en miroir par rapport à un plan imaginaire qui est perpendiculaire au substrat (3) à recouvrir.

9. Dispositif selon la revendication 8, caractérisé en ce que les normales des deux systèmes magnétiques (24, 25) forment un angle.

10. Dispositif selon la revendication 1, caractérisé en ce que la chambre (5) possède des ouvertures réticulées (8, 9) pour un échange de gaz.

11. Dispositif selon la revendication 1, caractérisé en ce que le système magnétique (11 ; 24, 25) comporte au moins un aimant permanent.

12. Dispositif selon la revendication 1, caractérisé en ce que la chambre (5) comporte au moins un dispositif de mise en tourbillonnement (10) de micro-ondes.

13. Dispositif selon la revendication 1, caractérisé en ce que la zone dans laquelle se produit la résonance de cyclotron pour électrons se trouve a 10 mm au moins devant les surfaces polaires du système magnétique (11, 24, 25).

14. Dispositif selon la revendication 1, caractérisé en ce que la chambre (5) comporte au moins une ouverture d'arrivée de gaz (4).

15. Dispositif selon la revendication 4, caractérisé en ce qu'il est prévu au moins un dispositif de mise en tourbillonnement (17) de micro-ondes dans l'émetteur de rayonnement à cornet (15).

16. Dispositif selon les revendications 12 et 15, caractérisé en ce que le dispositif de mise en tourbillonnement des micro-ondes (10, 17) est une roue à pales et peut tourner autour d'un axe, les différentes pales présentant une surface métallique.

17. Dispositif selon la revendication 1, caractérisé en ce que la chambre (5), formée par les parois métalliques (6, 7, 12, 13), se trouve à l'intérieur d'un boîtier (1) dans lequel il est possible de faire le vide.

18. Dispositif selon la revendication 17, caractérisé en ce que le boîtier (1) dans lequel il est possible de faire le vide, présente des ouvertures à travers lesquelles on peut transporter vers l'extérieur un substrat (3), par exemple en bande, et en ce que des moyens d'étanchéité (19, 20) sont prévus sur ces ouvertures.

19. Dispositif selon la revendication 4, caractérisé en ce qu'il est prévu sur au moins une paroi de l'émetteur de rayonnement en cornet (15) un dispositif (18) permettant d'influencer la distribution dans l'espace du champ de micro-ondes.

20. Dispositif selon la revendication 19, caractérisé en ce que le dispositif (18) est constitué de plusieurs barres en métal ou en diélectrique, à visser dans la paroi de l'émetteur en rayonnement en cornet (15).

21. Dispositif selon la revendication 1, caractérisé en ce que le support de substrat (3) présente des ajours (28, 29) à travers lesquels le front (21) de la résonance de cyclotron pour électrons peut agir sur le système magnétique (11).

22. Dispositif selon la revendication 11, caractérisé en ce qu'un système magnétique permanent (32) comporte une culasse (33) avec deux branches (34, 35) dont une branche (34) repose avec son pôle sud sur la culasse (33) et l'autre branche (35) avec son pôle nord.

23. Dispositif selon la revendication 11, caractérisé en ce que le système magnétique permanent possède trois branches (38, 39, 40) dont les deux branches (38, 40) extérieures sont reliées entre elles par des entretoises (44, 45) et enferment la branche intérieure (31).

24. Dispositif selon la revendication 11, caractérisé en ce que le système magnétique permanent comporte n aimants individuels (48 à 56) qui sont équidistants les uns des autres et possèdent chacun des extrémités polaires qui en ce qui concerne la polarité, diffèrent des extrémités polaires des aimants individuels voisins.

25. Dispositif selon la revendication 1, caractérisé en ce que la fenêtre d'entrée (14) est en liaison avec n émetteurs de rayonnement en cornet (64, 65), qui sont alimentés en micro-ondes par des distributeurs (62, 63).

26. Dispositif selon la revendication 1, caractérisé en ce que le générateur de micro-ondes comporte un émetteur de micro-ondes (71) qui est en liaison avec un émetteur de rayonnement en cornet (74), par un circulateur (72) et un tuner (73).

27. Dispositif selon la revendication 26, caractérisé en ce qu'il est prévu, entre l'émetteur de micro-ondes (71) et l'émetteur de rayonnement en cornet (74), un dispositif de mesure (75), destiné à mesurer la puissance réfléchie ainsi qu'un dispositif de mesure (76) destiné à mesurer la puissance en sens direct.

28. Dispositif selon les revendications 11, 22, 23 et 24, caractérisé en ce que les surfaces de sortie de pôle des différents aimants (par exemple 48 à 56) sont variables en profondeur ainsi qu'en distance réciproque.

29. Dispositif selon la revendication 6, caractérisé en ce que les zones du substrat (3) que traversent les lignes de champ magnétique présentent un blindage (77, 78).

30. Dispositif selon la revendication 6, caractérisé en ce que le substrat (3) est recouvert par un blindage (79, 80, 81), en ce que la zone du champ magnétique dans laquelle se produit la résonance de cyclotron pour électrons, se situe à l'extérieur de l'écran et que seules les zones dans lesquelles le champ magnétique traverse le substrat, restent ouvertes.

31. Dispositif selon la revendication 1, caractérisé en ce que dans la chambre (5) se trouve au moins une partie d'un cylindre (66) destiné à recouvrir un matériau (67) enroulable, un système magnétique (11) étant placé de manière que la zone de la résonance de cyclotron pour électrons se situe à l'extérieur du cylindre (66) et au-dessus de la zone de contact entre le substrat et le cylindre.

32. Dispositif selon la revendication 1, caractérisé en ce que la pression de procédé du gaz se situe entre $1 \times 10^{-4}$ et $1 \times 10^{-2}$ mbar.

33. Mise en oeuvre d'un dispositif selon l'une au moins des revendications 1 à 32 pour un procédé d'application d'une couche de protection en $SiO_x$, transparente dans le domaine de la lumière visible, x se situant entre 1 et 2, par décomposition d'un hydrure de silicium gazeux, par apport d'oxygène ou d'un composé oxygéné dans une décharge de plasma et dépôt du $SiO_x$ ainsi formé sur un miroir à effet avant formant un substrat, d'un réflecteur de projecteur.

34. Mise en oeuvre selon la revendication 33, caractérisée en ce qu'on introduit en plus un monomère gazeux du groupe des hydrocarbures de silicium dans la décharge de plasma.

FIG.1

FIG.2

# FIG.3

# FIG.4a

# FIG.4b

# FIG.4c

# FIG.4d

# FIG.4e

FIG.5

FIG.6

FIG.7

77                        78

3

N S   34   35  S N   82

33

# FIG.8a

79       80         81

3

N S   34   35  S N   82

33

# FIG.8b